# DEMANDE DE BREVET EUROPEEN

(11) **EP 0 629 865 A1**
(43) Date de publication de la demande: **21.12.1994**
(21) Numéro de dépôt: 94401307.7
(22) Date de dépôt: 10.06.1994
(51) Int. Cl.: G01R 29/10

(54) **Dispositif de positionnement d'antennes à l'intérieur d'une chambre anéchoique**

(30) Priorité: 15.06.1993 FR 9307178
(71) Demandeur: SIEPEL - Société Industrielle d'Etudes et Protection Electronique, F-56470 La Trinité-sur-Mer (FR)
(72) Inventeur: Ruelle, Philippe, F-56400 Pluneret (FR)
(74) Mandataire: Jaunez, Xavier

(57) **Abrégé**

L'invention concerne un dispositif de positionnement d'antennes comportant un ensemble (130) à mât porte-antennes (131) monté mobile dans une réservation (104) ménagée entre une paroi absorbante particulière (110) de la chambre de mesure (103) et la paroi adjacente de l'enveloppe (101) de cette chambre ; le mât (131) traverse cette paroi particulière (110) par une fente associée (105) pour s'étendre à l'intérieur de la chambre de mesure (103), chaque antenne (50, 51) étant montée à coulissement le long du mât (131), sans interférence mécanique avec les autres antennes portées par le mât, de façon à pouvoir positionner l'antenne désirée à l'emplacement voulu tout en escamotant l'autre ou les autres antennes dans la réservation (104), en arrière de la paroi particulière précitée.

## Description

La présente invention concerne le positionnement des antennes à l'intérieur de chambres de mesure de type anéchoïque ou semi-anéchoïque.

De telles chambres sont constituées par une enveloppe à l'intérieur de laquelle sont disposés des blocs absorbants électromagnétiques formant les parois absorbantes de la chambre. Pour une chambre de type anéchoïque, toutes les parois sont recouvertes de matériaux absorbants électromagnétiques, alors que pour une chambre de type semi-anéchoïque le sol ne comporte pas de blocs absorbants électromagnétiques (voir FR-A-2.631.452, FR-A-2.623.288, JP-A-04 169 865).

De telles enceintes partiellement ou totalement tapissées de blocs absorbant les ondes électromagnétiques sont couramment utilisées pour tester des antennes ou pour mesurer le niveau de rayonnement d'un matériel sur une gamme de fréquences données, et ce dans des domaines techniques variés (véhicules automobiles, satellites, téléphones, etc...), de telles mesures permettant par exemple de vérifier qu'un matériel spécifique à courants faibles fonctionne encore correctement dans un champ électromagnétique élevé, pour des fréquences données qui correspondent au type de matériel concerné.

Le positionnement des antennes dans une telle installation est traditionnellement organisé en utilisant un chariot sur lequel est monté un mât vertical supportant une antenne (ou parfois deux antennes) avec possibilité d'un réglage de la hauteur.

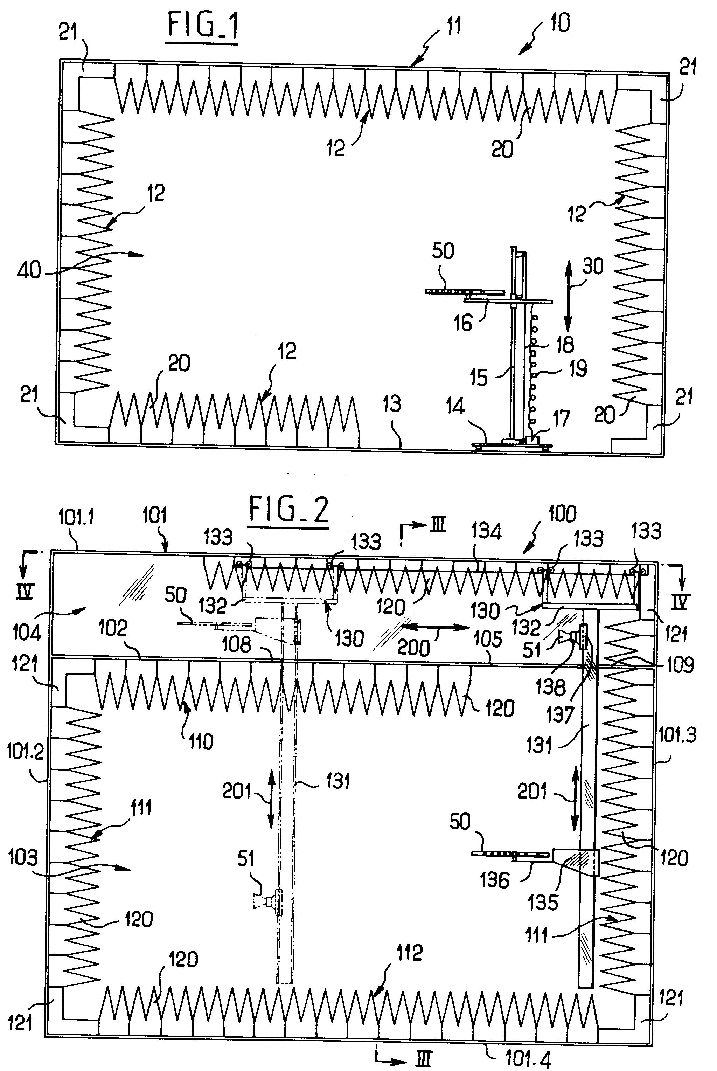

Un tel dispositif connu de positionnement est illustré sur la figure 1.

On distingue sur cette figure une chambre de mesure 10 (vue en coupe longitudinale) constitué par une enveloppe parallélépipédique 11 à l'intérieur de laquelle sont disposés des blocs d'absorption électromagnétique (cônes absorbants 20 et coins absorbants 21) formant les parois absorbantes 12 qui délimitent l'espace intérieur 40 de la chambre. En l'espèce, une partie du plancher 13 est exempte de blocs absorbants afin de disposer d'un plan sur lequel peut évoluer un chariot 14. Le chariot 14 supporte un mât vertical 15, sur lequel coulisse un support 16 dont la hauteur est réglable par un système à moteur 17 et filin 18, comme schématisé par la flèche 30, et sur lequel est accrochée une liaison coaxiale 19. Sur le support 16, on a monté une antenne 50 de type filaire, dont le positionnement dans l'espace intérieur 40 est ainsi réglé de façon appropriée en vue d'un test ou d'une mesure spécifique.

Lorsque l'on veut changer d'antenne afin d'effectuer un test ou une mesure sur une autre gamme de fréquences, par exemple en utilisant un cornet hyperfréquence, il est nécessaire d'arrêter le test en cours, de pénétrer dans la chambre, d'enlever l'antenne du mât et de monter une autre antenne compatible avec la nouvelle gamme de fréquences dans laquelle on veut travailler, et enfin de repositionner la nouvelle antenne à l'emplacement désiré.

Ces différentes opérations demandent un temps important (en général au moins une heure), ce qui grève lourdement le coût des tests ou mesures effectués. D'autre part, dans le cas d'une chambre de mesure anéchoïque, il est nécessaire de déposer les blocs d'absorbants pour pouvoir accéder au chariot.

Pour éviter de telles contraintes, on a proposé de modifier la structure du dispositif précédent pour pouvoir monter deux antennes sur le mât du chariot. Cependant, dans la pratique, on ne peut laisser les deux antennes simultanément en place, car l'antenne qui n'est pas utilisée constitue une source de perturbations non négligeables du champ électromagnétique. Il faut alors que l'opérateur rentre dans la chambre pour démonter l'antenne qui n'est pas utilisée, et un tel mouvement perturbe naturellement l'équilibre qui régnait dans cette chambre.

L'invention a précisément pour but de résoudre ce problème en concevant un nouveau moyen de positionnement ne présentant pas les inconvénients précités.

L'invention a ainsi pour objet de réaliser un dispositif de positionnement d'antennes permettant d'une part l'utilisation de deux ou plusieurs antennes sans dépose, et d'autre part un changement rapide d'antenne, sans que ce changement n'induise des perturbations sensibles du champ électromagnétique dans la chambre de mesure, avec en outre la possibilité d'utiliser un tel dispositif pour des chambres anéchoïques ou semi-anéchoïques de dimensionnements variés.

Il s'agit plus particulièrement d'un dispositif de positionnement d'antennes à l'intérieur d'une chambre de mesure de type anéchoïque ou semi-anéchoïque constituée par une enveloppe à l'intérieur de laquelle sont disposés des blocs absorbants électromagnétiques formant les parois absorbantes de cette chambre de mesure, caractérisé en ce qu'une réservation est ménagée entre une paroi absorbante particulière de la chambre de mesure et la paroi adjacente de l'enveloppe de ladite chambre, et en ce qu'un ensemble à mât porte-antennes est monté mobile dans cette réservation, ledit mât traversant cette paroi particulière par une ouverture associée de celle-ci pour s'étendre à l'intérieur de la chambre de mesure, chaque antenne étant montée à coulissement le long de ce mât, sans interférence mécanique avec les autres antennes portées par ledit mât, de façon à pouvoir positionner l'antenne désirée à l'emplacement voulu dans la chambre de mesure tout en escamotant l'autre ou les autres antennes dans ladite réservation, en arrière de ladite paroi particulière.

Dans un mode d'exécution particulier, la paroi particulière constitue un faux-plafond de la chambre de mesure, et le mât porte-antennes est suspendu verticalement à l'ensemble mobile. En variante, la paroi particulière constitue un faux-plancher de la chambre de mesure, et le mât porte-antennes est porté verticalement par l'ensemble mobile. On peut même envisager que cette paroi particulière soit une paroi latérale, le mât étant alors horizontal et s'étendant en porte-à-faux dans la chambre de mesure (la présence du porte-à-faux est cependant moins favorable pour l'obtention de déplacements précis, de sorte que l'on préférera en général un agencement dans lequel le mât porte-antennes est vertical).

De préférence, l'ensemble mobile est un chariot déplaçable en translation dans la réservation associée par l'intermédiaire de glissières ou rails agencés horizontalement.

Avantageusement en outre, l'ouverture associée est constituée par une fente rectiligne dont la direction est la direction de déplacement du chariot et dont la largeur est choisie pour laisser juste passer le mât porte-antennes, et un passage plus large communiquant avec cette fente, dont le contour est choisi pour permettre le passage de l'antenne la plus encombrante. Il est alors intéressant que le chariot soit déplaçable entre deux positions extrêmes, dont l'une dans laquelle le mât porte-antennes est au voisinage de l'extrémité de la fente rectiligne, et l'autre dans laquelle le mât porte-antennes est au niveau du passage plus large.

Conformément à une caractéristique particulière, le mât porte-antennes est un profilé sur lequel sont agencés des coulisseaux individuels porte-antenne roulant chacun sur une piste associée dudit profilé.

Avantageusement alors, le mât porte-antennes est un profilé à section en I ou analogue, sur les ailes d'extrémité duquel viennent s'accrocher deux coulisseaux portant chacun une antenne, par exemple un cornet hyperfréquence et une antenne filaire triangulaire. En particulier, les deux coulisseaux sont agencés de telle façon que les deux antennes soient toujours disposées d'un même côté du mât porte-antennes.

De préférence enfin, le mât porte-antennes et les organes de support associés à chaque antenne sont réalisés en un matériau électromagnétiquement non réfléchissant, par exemple en polychlorure de vinyle.

D'autres caractéristiques et avantages de l'invention apparaîtront plus clairement à la lumière de la description qui va suivre et des dessins annexés, concernant un mode de réalisation particulier, en référence aux figures 2 à 8, où :
- la figure 2 illustre en coupe longitudinale une chambre de mesure équipée d'un dispositif de positionnement d'antennes conforme à l'invention, la réservation étant ici prévue en plafond, au-dessus d'un faux-plafond ;
- les figures 3 et 4 sont des coupes selon III-III et IV-IV de la figure 2 permettant de mieux distinguer la structure particulière du dispositif de positionnement ;
- les figures 5 et 6 sont deux vues partielles en élévation du mât porte-antennes du dispositif précité, au niveau des coulisseaux correspondants sur lesquels sont montées les deux antennes concernées ;
- la figure 7 est une vue de dessus de l'ensemble représenté à la figure 5, dans une coupe selon VII-VII de la figure 5, et la figure 8 illustre à plus grande échelle le détail VIII de la figure 7.

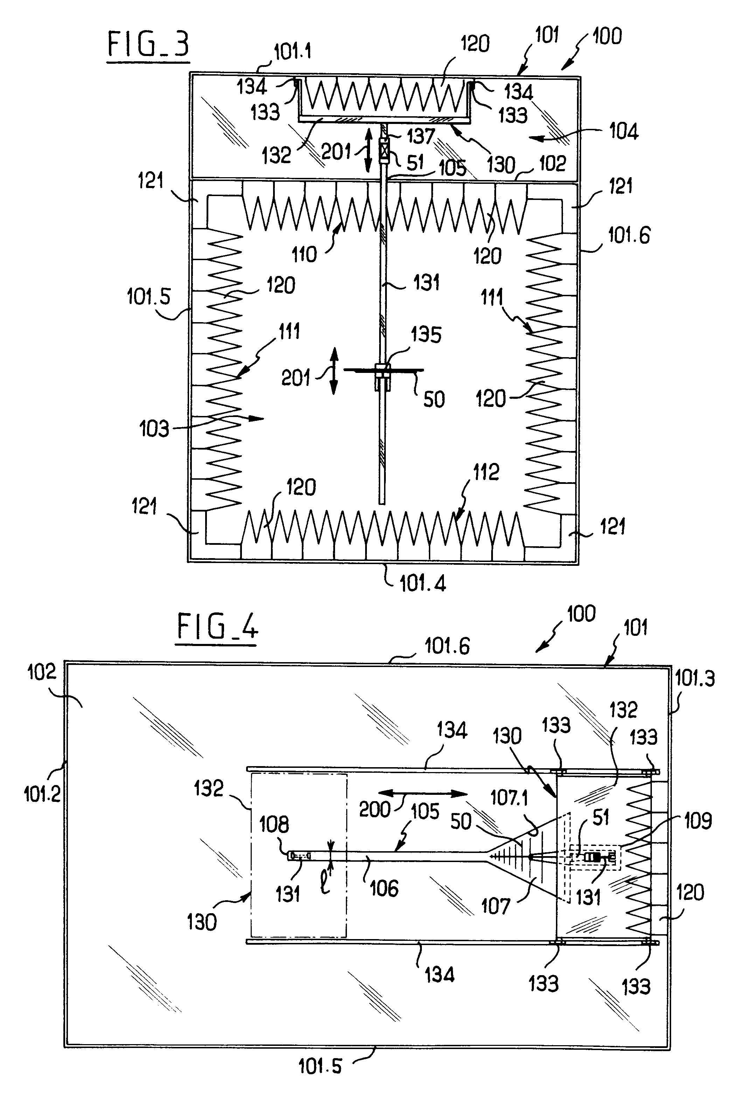

Les figures 2 et 3 permettent de distinguer une enceinte (faradisée ou non) 100 équipée d'absorbants, constituée par une enveloppe 101 comportant un plafond 101.1, un plancher 101.4, et des parois verticales latérales 101.2, 101.3, 101.5, 101.6. La chambre de mesure 103 est délimitée par des parois formées par des blocs d'absorbants électromagnétiques de type conventionnel, avec des cônes 120 et des coins 121. Le plancher 101.4 est ici entièrement revêtu de blocs électromagnétiquement absorbants car il s'agit d'une chambre de mesure de type anéchoïque, mais il va de soi que l'invention s'appliquera tout aussi bien à une chambre de mesure de type semi-anéchoïque, dans laquelle le plancher n'est que partiellement ou pas du tout revêtu de blocs absorbants.

Conformément à un aspect essentiel de l'invention, une réservation est ménagée entre une paroi absorbante particulière de la chambre de mesure et la paroi adjacente de l'enveloppe de ladite chambre. En l'espèce, cette paroi particulière est une paroi supérieure 110 constituant un faux-plafond de la chambre de mesure 103. Cette paroi particulière 110 est constituée par une dalle horizontale 102, sur la face inférieure de laquelle sont disposés des blocs absorbants 120 ainsi que des coins 121. La cage de mesure 103 est ainsi délimitée par cette paroi supérieure 110 qui en constitue le plafond, la paroi de base 112 qui en constitue le plancher, et quatre parois latérales 111. La réservation 104 constitue dans ce cas une surélévation particulière des chambres classiques.

Un ensemble 130 à mât porte-antennes 131 est alors monté mobile dans cette réservation 104, ledit mât traversant cette paroi particulière 110 par une ouverture associée 105 de celle-ci pour s'étendre à l'intérieur de la chambre de mesure 103. L'ensemble mobile 130 représenté ici est un chariot 132 qui est déplaçable en translation dans la réservation associée 104 par l'intermédiaire de deux glissières ou rails 134 agencés horizontalement, ledit chariot étant accroché par des roulettes associées 133, et les glissières ou rails 134 étant fixés en face inférieure de la cloison supérieure 101.1 de l'enveloppe 101. Le mât porte-antennes 131 est alors suspendu verticalement à l'ensemble mobile 130. Dans le dispositif illustré ici, l'ensemble mobile ne supporte qu'un mât unique 131 portant deux antennes 50, 51, mais il va de soi que ceci ne constitue qu'un exemple, et l'on pourra prévoir un mât porte-antennes dont la structure permet de porter à coulissement plus de deux antennes et/ou prévoir un deuxième mât accroché sur le même chariot déplaçable en translation, ce deuxième mât portant lui-même une ou plusieurs antennes. Chaque antenne 50, 51 est montée à coulissement le long du mât 131, sans interférence mécanique avec les autres antennes portées par ledit mât, de façon à pouvoir positionner l'antenne désirée à l'emplacement voulu dans la chambre de mesure 103 tout en escamotant l'autre ou les autres antennes dans la réservation 104, en arrière de la paroi particulière 110. Les liaisons coaxiales associées (non représentées) seront de préférence intégrées au mât porte-antennes 131.

L'équipage mobile constitué par le chariot 132 et son mât porte-antennes 131 est ainsi déplaçable longitudinalement, et l'on a représenté sur la figure 2, les deux positions extrêmes de cet équipage mobile. On a en outre représenté en trait continu une position qui correspond à la sélection de l'antenne désirée et à la remontée de l'autre ou des autres antennes au niveau de la réservation 104. On a représenté en traits mixtes l'autre position extrême, qui est l'une des positions dans laquelle on effectue le test ou la mesure concerné, avec l'antenne sélectionnée, ici un cornet hyperfréquence 51, tandis que l'autre antenne ou les autres antennes, ici une antenne filaire 50, sont escamotées dans la réservation 104 en arrière de la paroi constituant le faux-plafond de la chambre de mesure 103. L'antenne sélectionnée est naturellement positionnée à la hauteur désirée, grâce à un système de coulisseau qui sera décrit plus loin, comme schématisé par la flèche 201.

Si l'on veut utiliser l'antenne filaire 50 à la place du cornet hyperfréquence 51, il suffit, à partir de la position illustrée en traits mixtes, de déplacer le chariot 132 avec son mât porte-antennes 131 vers son autre position d'extrémité, puis alors de remonter le cornet hyperfréquence 51 et d'abaisser l'antenne filaire 50 à la hauteur désirée, et enfin de déplacer à nouveau le chariot 132 avec son mât porte-antennes dans une nouvelle position de mesure qui peut être la position illustrée en traits mixtes sur la figure 2 ou une position voisine. Dans cette nouvelle position, l'antenne filaire 50 est utilisée normalement, comme si cette antenne était la seule antenne du mât, alors que le cornet hyperfréquence 51 est quant à lui confiné dans sa réservation 104. Le déplacement horizontal du chariot est schématisé par la flèche 200.

Il est aisé de comprendre que l'antenne escamotée n'induit aucune perturbation du champ électromagnétique régnant à l'intérieur de la chambre de mesure 103 grâce à la présence de la paroi absorbante particulière 110 qui isole totalement l'antenne escamotée de cette chambre de mesure. De plus, la substitution d'antennes peut se faire rapidement, et surtout sans avoir à accéder à l'intérieur de l'enceinte.

L'ouverture 105 par laquelle le mât porte-antennes 131 traverse le faux-plafond de la chambre de mesure doit à cet effet présenter une géométrie parfaitement adaptée pour limiter au maximum les réflexions électromagnétiques. Ainsi que cela est mieux visible sur la figure 4, l'ouverture 105 est en l'espèce constituée par une fente rectiligne 106, dont la direction correspond à la direction de déplacement 200 du chariot 132, et dont la largeur 1 est choisie pour laisser juste passer le mât porte-antennes 131, et par un passage plus large 107 communiquant avec cette fente, passage dont le contour 107.1 est choisi pour permettre le passage de l'antenne la plus encombrante, c'est-à-dire en l'espèce l'antenne filaire 50. Le chariot 132 est alors déplaçable entre deux positions extrêmes, dont une position illustrée en traits mixtes dans laquelle le mât porte-antennes 131 est au voisinage de l'extrémité 108 de la fente rectiligne 106, et l'autre illustrée en trait continu dans laquelle le mât porte-antennes 131 est au niveau du passage plus large 107. Dans cette dernière position, l'antenne filaire 50, ici de forme triangulaire, est exactement à la verticale du contour de forme adaptée faisant partie du passage 107, ce passage plus large se terminant au niveau d'une extrémité 109 par une fente laissant passer les coulisseaux sur lesquels sont montées des antennes 50 et 51, afin de pouvoir effectuer librement le mouvement de remontée de l'une ou l'autre de ces deux antennes jusque dans la réservation 104.

Pour parfaire l'absorption électromagnétique, on a également prévu, au niveau du plafond de la réservation 104, et au niveau du passage élargi du faux-plafond, des blocs absorbants 120, 121 analogues à ceux précédemment mentionnés pour former les parois de la chambre de mesure 103.

Ainsi que cela a été dit plus haut, il est possible de faire en sorte que la paroi absorbante particulière délimitant la réservation constitue un faux plancher de la chambre de mesure (variante non représentée) : dans ce cas, le mât porte-antennes 131 est porté verticalement par un chariot qui se déplace dans la réservation associée, en-dessous du plancher 112 de la chambre de mesure 103, le mât 131 passant alors dans une ouverture de la paroi de plancher 101.4, ouverture qui peut être agencée avec la même géométrie que l'ouverture à fente 106 et passage élargi 107 précédemment décrite.

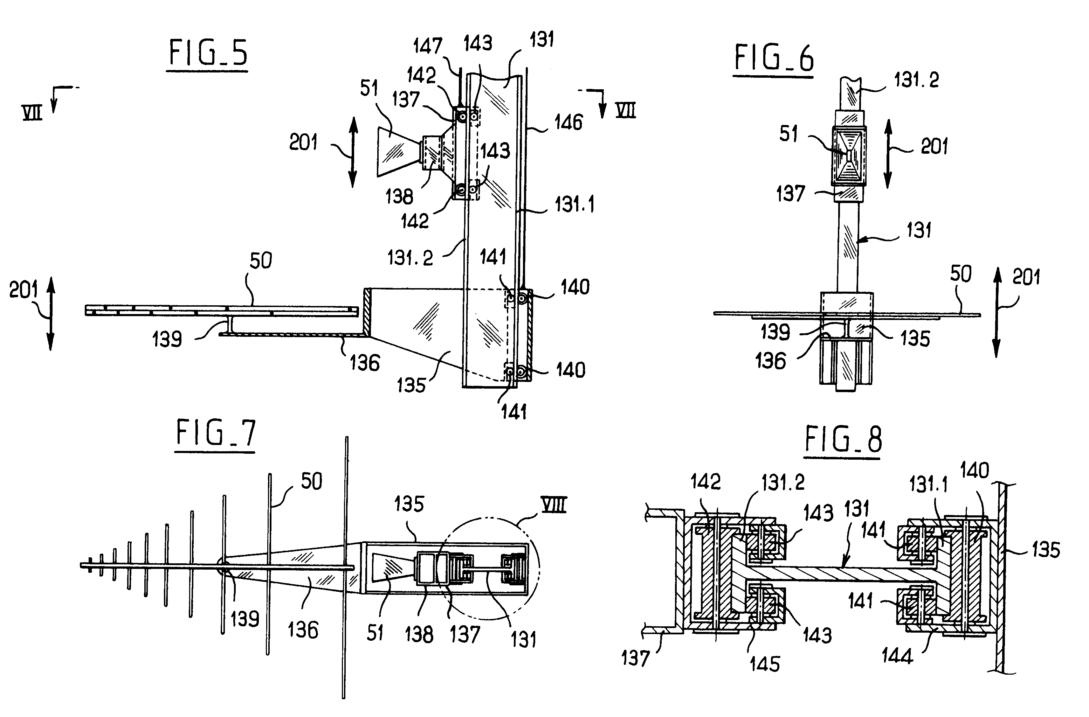

On va maintenant décrire, en se référant aux figures 5 à 8, un mode d'exécution particulier du montage des deux antennes précitées 50, 51 sur le mât porte-antennes 131, ce montage étant tel que l'on peut positionner chaque antenne à la hauteur voulue, et escamoter l'autre antenne qui n'est pas utilisée, sans qu'il y ait interférence mécanique entre ces antennes.

Le mât porte-antennes 131 peut être un profilé à section en I ou analogue, sur lequel sont agencés des coulisseaux individuels 135 et 137 qui se déplacent verticalement sur le profilé. Etant donné que le mât 131 ne porte ici que deux antennes, on peut utiliser les ailes d'extrémité 131.1 et 131.2 du profilé à section en I pour constituer des pistes associées à chacun des coulisseaux 135 et 137. Ainsi, le coulisseau 135 associé à l'antenne filaire 50 présente un contour (ici rectangulaire) suffisamment large pour permettre le passage de l'autre antenne 51 qui est ici un cornet hyperfréquence, et du coulisseau associé à cette dernière antenne. Le coulisseau 135 est accroché sur l'aile 131.1, au moyen de deux rouleaux de contact 140, le maintien étant assuré par deux paires de roulettes 141 qui sont en appui du côté opposé de cette aile 131.1, le rouleau 140 et les roulettes 141 étant portés par un étrier 144 rigidement solidaire de la face arrière du coulisseau 135. On est alors assuré du parfait maintien de l'horizontalité du coulisseau 135, dont la hauteur peut être réglée par tout moyen, par exemple avec un filin 146 relié à un organe de levage non représenté ici. De l'autre côté, le coulisseau 135 est équipé d'un support allongé 136 qui se termine par un plot 139 sur lequel est montée l'antenne filaire 50. Pour le cornet hyperfréquence 51, on trouve de la même façon un coulisseau 137 équipé d'un support d'antenne 138, ce coulisseau roulant par des rouleaux 142 contre l'autre aile 131.2 du profilé en I, le maintien étant assuré par des roulettes 143, les rouleaux 142 et les deux paires de roulettes 143 étant portés par un étrier 145 solidaire du coulisseau 137, conformément à un montage symétrique de celui déjà décrit pour le coulisseau 135. Le réglage en hauteur du cornet hyperfréquence 51 peut être alors assuré par un filin 147 également relié à un organe de levage non représenté ici.

Un tel agencement permet de déplacer verticalement chacune des antennes, d'une part pour disposer l'antenne désirée à la hauteur voulue, et d'autre part pour remonter l'autre antenne au niveau de la réservation de l'enceinte 100 en vue de l'escamotage de cette dernière antenne. L'agencement qui vient d'être décrit présente l'avantage que les deux antennes 50 et 51 sont toujours disposées d'un même côté du mât porte-antennes 131. De cette façon, l'antenne sélectionnée est toujours disposée dans une position prête à la mesure. On aurait pû prévoir une autre disposition, mais avec l'organisation d'un montage tournant du mât porte-antennes 131, la rotation du mât autour d'un axe vertical permettant d'amener l'antenne sélectionnée à la position désirée dans l'axe de la mesure.

Le mât porte-antennes 131 et les organes de support 135 à 147 associés à chaque antenne 50, 51, seront de préférence réalisés en un matériau électromagnétiquement non réfléchissant, par exemple en polychlorure de vinyle.

Si l'on souhaite disposer de plus de deux antennes, on pourra alors choisir un profilé de section différente, par exemple cruciforme, chaque branche du profilé portant alors un coulisseau individuel sur lequel est montée une antenne. L'ouverture de passage dans le faux-plafond devra alors être agencée en conséquence, pour pouvoir escamoter les antennes qui ne sont pas utilisées.

La structure du dispositif qui vient d'être décrit s'accomode parfaitement de chambres de mesure de grandes dimensions, par exemple une hauteur de six mètres et une longueur de neuf mètres. En effet, les glissières ou rails sur lesquels est accroché le chariot déplaçable permet d'assurer une précision de l'ordre du millimètre, de sorte que l'antenne sélectionnée se trouve toujours orientée correctement avec une excellente précision pour effectuer le test ou la mesure désiré.

On est ainsi parvenu à réaliser un dispositif de positionnement d'antennes permettant d'une part l'utilisation de deux ou plusieurs antennes sans dépose, et d'autre part un changement rapide d'antenne, sans que ce changement n'induise de perturbations sensibles du champ électromagnétique dans la chambre de mesure, avec en outre la possibilité d'utiliser un tel dispositif pour des chambres anéchoïques ou semi-anéchoïques de dimensions variées.

L'invention n'est pas limitée au mode de réalisation qui vient d'être décrit, mais englobe au contraire toute variante reprenant, avec des moyens équivalents, les caractéristiques essentielles énoncées plus haut.

## Revendications

1. Dispositif de positionnement d'antennes à l'intérieur d'une chambre de mesure de type anéchoïque ou semi-anéchoïque constituée par une enveloppe à l'intérieur de laquelle sont disposés des blocs absorbants électromagnétiques formant les parois absorbantes de cette chambre de mesure, caractérisé en ce qu'une réservation (104) est ménagée entre une paroi absorbante particulière (110) de la chambre de mesure (103) et la paroi adjacente (101.1) de l'enveloppe (101) de ladite chambre, et en ce qu'un ensemble (130) à mât porte-antennes (131) est monté mobile dans cette réservation (104), ledit mât traversant cette paroi particulière par une ouverture associée (105) de celle-ci pour s'étendre à l'intérieur de la chambre de mesure (103), chaque antenne (50, 51) étant montée à coulissement le long de ce mât (131), sans interférence mécanique avec les autres antennes portées par ledit mât, de façon à pouvoir positionner l'antenne désirée à l'emplacement voulu dans la chambre de mesure (103) tout en escamotant l'autre ou les autres antennes dans ladite réservation, en arrière de ladite paroi particulière.

2. Dispositif selon la revendication 1, caractérisé en ce que la paroi particulière (110) constitue un faux-plafond de la chambre de mesure (103), et le mât porte-antennes (131) est suspendu verticalement à l'ensemble mobile (130).

3. Dispositif selon la revendication 1, caractérisé en ce que la paroi particulière constitue un faux-plancher de la chambre de mesure, et le mât porte-antennes (131) est porté verticalement par l'ensemble mobile (130).

4. Dispositif selon la revendication 2 ou la revendication 3, caractérisé en ce que l'ensemble mobile (130) est un chariot (132) déplaçable en translation dans la réservation associée (104) par l'intermédiaire de glissières ou rails (134) agencés horizontalement.

5. Dispositif selon l'une des revendications 1 à 4, caractérisé en ce que l'ouverture associée (105) est constituée par une fente rectiligne (106) dont la direction est la direction de déplacement du chariot (132) et dont la largeur (1) est choisie pour laisser juste passer le mât porte-antennes (131), et un passage plus large (107) communiquant avec cette fente, dont le contour (107.1) est choisi pour permettre le passage de l'antenne la plus encombrante.

6. Dispositif selon les revendications 4 et 5, caractérisé en ce que le chariot (132) est déplaçable entre deux positions extrêmes, dont l'une dans laquelle le mât porte-antennes (131) est au voisinage de l'extrémité (108) de la fente rectiligne (106), et l'autre dans laquelle le mât porte-antennes (131) est au niveau du passage plus large (107).

7. Dispositif selon l'une des revendications 1 à 6, caractérisé en ce que le mât porte-antennes (131) est un profilé sur lequel sont agencés des coulisseaux individuels (135 ; 137) porte-antenne (50 ; 51) roulant chacun sur une piste associée dudit profilé.

8. Dispositif selon la revendication 7, caractérisé en ce que le mât porte-antennes (131) est un profilé à section en I ou analogue, sur les ailes d'extrémité (131.1 131.2) duquel viennent s'accrocher deux coulisseaux (135 ; 137) portant chacun une antenne (50 ; 51), par exemple un cornet hyperfréquence (51) et une antenne filaire triangulaire (50).

9. Dispositif selon la revendication 8, caractérisé en ce que les deux coulisseaux (135 ; 137) sont agencés de telle façon que les deux antennes (50 ; 51) soient toujours disposées d'un même côté du mât porte-antennes (131).

10. Dispositif selon l'une des revendications 1 à 9, caractérisé en ce que le mât porte-antennes (131) et les organes de support (135 à 147) associés à chaque antenne (50 51) sont réalisés en un matériau électromagnétiquement non réfléchissant, par exemple en polychlorure de vinyle.
